Europäisches Patentamt

European Patent Office

Office européen des brevets

(11) Publication number: **0 148 549**
**B1**

## EUROPEAN PATENT SPECIFICATION

(45) Date of publication of patent specification: 08.08.90

(21) Application number: 84301193.3

(22) Date of filing: 24.02.84

(51) Int. Cl.⁵: **B 41 M 1/14,** G 03 F 3/04

(54) Improved colour reproduction process.

(30) Priority: 23.12.83 CA 444261

(43) Date of publication of application:
17.07.85 Bulletin 85/29

(45) Publication of the grant of the patent:
08.08.90 Bulletin 90/32

(84) Designated Contracting States:
AT BE CH DE FR GB IT LI LU NL SE

(56) References cited:
FR-A- 330 962     US-A-3 692 519
US-A-2 997 389    US-A-3 862 848
US-A-3 043 686    US-A-3 884 686
US-A-3 253 917

ILFORD MANUAL OF PROCESS WORK, 5th
edition 1951, pages 415-416, Ilford Ltd., Ilford,
London, GB; L.P. CLERC: Paragraph 407:
"Seperation into two complementary colours";
paragraph 408: "Facsimile reproductions in two
colours"
Idem
Idem

(73) Proprietor: MARK I MARKETING
CORPORATION
P.O. Box 1265 Station B
Weston Ontario M9G 2R9 (CA)

(72) Inventor: Edwards, Wallace
P.O. Box 1265 Station B
Weston Ontario M9G 2R9 (CA)

(74) Representative: Beresford, Keith Denis Lewis
et al
BERESFORD & Co. 2-5 Warwick Court High
Holborn
London WC1R 5DJ (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates generally to the printing industry, and has to do particularly with a process for the generation of the plates necessary to permit colour printing. Even more particularly, the present invention sets forth a method of reducing the number of individual plates which need to be made to satisfactorily reproduce a given coloured picture, painting, transparency or the like.

Background of this invention

Currently, a process known as the four-colour separation process is very widely used in the printed reproduction of coloured pictures, transparencies and the like. The four-colour separation process is generally responsible for all of the high-quality coloured reproductions in magazines and books, and is also used for some newspaper work as well.

In the most common version of this process, the original print or transparency is photographed through different filters to produce different individual films which correspond to the basic colours of the four-colour separation process. The filters utilized have tints which are the complementary colours of the colours being drawn out. A combination of all filters is ideally utilized to pick out the black, although in some processes the black film is made by photographing the original in black-and-white film, without any filter.

Some "fine tuning" or adjustment of the intensities of the various colours in the process is made by selecting exposure times and development times. Also, in some instances the final inks used to print the final reproduction can be varied and selected to attain certain effects.

From the four pieces of film produced through this process printing plates are made, these being subequently attached to plate rollers in a typical printing machine, which is then able to print the reproduction.

Generally speaking, the printing industry is of the view that proper reproduction of any photograph or the like requires a four-colour separation process of the kind just described.

However, in certain branches of the printing industry, particularly in newspapers, shopping bags, the Yellow Pages and advertising flyers, the full four-colour separation process represents a considerable expense, since it requires the material to be passed through four printing stations, in order to receive the four colours. This in turn requires the production of four plates, and the time required to mount them, adjust the components, etc. All of this represents a substantial cost factor which, for obvious reasons, it would be of advantage to reduce.

There is a two-ink process forming part of the prior art, known as duotone. In one version of this process, often called "Fake" duotone, a black and white original (for example a photograph) is first photographed on "Ortho" film through a contact screen to give a black and white continous tone picture. "Ortho" film is a high contrast film which is not sensitive to the red region of the spectrum. Then, the same screen is rotated through 30° and another black and white picture is taken, substantially identical to the first, also on "Ortho" film. The two films are developed to different densities, then are used to make plates which are run in two colours, for example, red and black.

In another version of duotone, often called "Real" duotone, the orignial art is already in two colours, for example, red and black. The first step is to shoot "Ortho" film through a grey contact screen without any filter. Both the red and the black will be seen by the film, and the result will be a film in which the red and the black are both picked up as black. Then, a panchromatic film is exposed through a red filter and a grey contact screen. In this arrangement, the film sees only black.

The two films are then used to make plates which print red and black, respectively.

It is also known, particularly in the food advertising area where blue colours are rare, to do a three-colour separation using the standard filters and then to print the image using yellow ink, red ink and black ink.

It is further known to mix various colours to produce various other colours. For example, it is known to print a dot matrix of black superimposed on a dot matrix of yellow in order to produce various shades of green.

The "Ilford Manual of Process Work" by L.B. Clerc, fifth addition, 1951, published by Ilford Limited, Ilford, London, describes at page 416 a colour printing process using just two coloured inks in which, for instance, a vermillion-red and a green blue ink are utilized. The exposure corresponding to the first of these inks may be effected in two stages, successively through the standard blue-violet and green filters used for three-colour separation (each exposure being one-half the exposure which by itself would give a normal image), while the green-blue printing negative will be executed under the standard red filter for three-colour work. While the manual is not entirely clear on this point, it appears that fine-etchers' work is still required in such a process.

General description of this invention

The object of the present invention is to mitigate the disadvantages of the above mentioned processes.

In accordance with the present invention, there is provided a method of printing on a sheet member a realistic image of an original, utilizing two different superimposed impressions with two different colouring media, the method including the steps of creating a first printing plate by the interposition of filter means between the original and a means for recording a first optical image, creating a second printing plate by the interposition of filter means between the original and means for recording a second optical image, and using the first and second plates to print the different impressions with two different colouring media, the first printing plate being created by the interposition of at least two different filters between the original and the said means for recording a first optical image, said different filters being adapted to filter out different colours or combinations of colours, characterised in that the contribution to said first optical image obtained utilizing one of said at least two different filters is considerably less than the contribution to said first optical image obtained utilizing the other of said at least two different filters.

Utilizing the present invention, it is possible to attain strikingly realistic reproductions of an original utilizing only two printing plates inked with only two different colours. However, the process of making these plates does not involve simply one of the known parts of the standard four-colour separation.

By way of explaining this, it should be understood that, if a four-colour separation were made to produce four plates intended to print the basic colours of the four-colour separation process and then if only two were printed, or only three , or any other combination which was not the full combination of four colours, the resulting print would be clearly and definitely unbalanced, and anyone viewing the print would immediately see the unbalanced nature of the colours. The print would appear "too reddish" or "too far into the blue region", or blotchy. The aim of the process which I have developed is to remove the unbalanced nature of a printed reproduction made with only two impressions, and thus two inks.

In a preferred embodiment, the means for recording the first and second optical images are pieces of photographic film, and the colouring media are printing inks.

The filters are chosen from among the colours blue, green and red. The sheet member may be white or coloured, for example yellow.

Detailed description of this invention

This invention will first be described as it relates to the printing industry, and subsequently as it relates to the copying industry.

When used in the photographic reproduction area, the method of this invention involves making two films by exposure to the original, at least one of the films being made by the interposition of at least two filters between the original and the film during exposure. The filters are used sequentially, rather than together at the same time. The second film may be made in the normal way to select out another colour, utilizing only a single filter. In a more complex version, the second film may also be the result of utilizing two filters sequentially.

As an example, consider the problem of printing a picture of a baby's face with blue eyes against a light blue background. The final print is to be made on white paper.

Let us assume that the first film to be made will be that for the plate intended to print red ink. In order to pick out the red tints, a green filter is first utilized, and this produces a first exposure on the film. Then, in accordance with this invention, a second filter would be utilized. In this example, I would typically utilize a filter to draw out some of the blue, for example the blue eyes of the baby. This would also pick up some of the blue background. However, for this filter I would adjust the exposures so that the film contained more of the red than the blue, in order to clean out the red tone in the blue eyes, while still leaving enough to enhance the contrast.

The second film would be that intended to make a plate for printing blue ink. In this example, the "blue" film would be exposed only through one filter.

Suppose now that the same picture of the baby against a blue background were to be printed on yellow stock, for example as a telephone advertisement in the Yellow Pages. In this case, one of the two inks must be black, since the normal "word" advertisements are printed in black. Because the baby's face is predominantly pink or flesh tone, the coloured ink would be red. However, instead of merely using a green filter, one would use first a green filter to draw out the red tones, and then a filter to "fill in" the blue regions, for example the baby's eyes and the background. The blue contribution would be considerably less than the red, so that the eyes when printed with red ink would not be obviously red.

Nonetheless, there would be some ink printed where the original showed blue (the eyes and the background), and therefore the final printed image would be a continuous one in which all major components were present. The second film (intended to print black) would be exposed through a filter such as to provide the addition of black dots to the blue areas to give it the detail and resolution required.

This can be compared to an attempt to print the same picture of a blue-eyed baby against a blue background using only the black and red films from a standard four-colour separation. In this instance, the result would be a flat picture with insufficient contrast.

In regard to the copying industry, it is well understood that the copying process involves the establishment of a latent electrostatic image on a drum or plate constituting a photoconductive surface, following which a coloured "toner" is applied to the image-containing portions of the photoconductive surface, the electrical attraction causing the toner to remain in certain areas and be removed from others, following which the photoconductive surface with the toner is applied a sheet of paper which picks up the toner as an image. Copiers are known which are capable of colour reproduction. These copiers work on a principle similar to that utilized in the four-colour separation process described earlier, namely that the photoconductive surface is exposed four times sequentially to the original, each time through a different coloured filter. Following each exposure to establish the electrostatic image, a coloured toner is applied to the surface, and the sheet is printed with that particular colour. Then the surface is cleaned, exposed again to the next filter, then the next toner is applied, and the same sheet is again printed with the new colour. This continues for all four colours.

It will be evident that the essence of this invention can be applied to the copying industry, by arranging to have the photoconductive surface exposed through not one but two (or more) filters. These filters ideally would be used sequentially to build up an electrostatic image which is a composite of the images which would normally be obtained through the two different coloured filters. Then this composite electrostatic image is contacted by the appropriate coloured toner, and the same is printed on the paper sheet.

While one embodiment of this invention has been described above, it will be evident to those skilled in the art that changes and modifications may be made therein without departing from the scope of the appended claims.

## Claims

1. A method of printing on a sheet member a realistic image of an original, utilizing two different superimposed impressions with two different colouring media, the method including the steps of creating a first printing plate by the interposition of filter means between the original and a means for recording a first optical image, creating a second printing plate by the interposition of filter means between the original and means for recording a second optical image, and using the first and second plates to print the different impression with two different colouring media, the first printing plate being created by the interposition or at least two different filters between the original and the said means for recording a first optical image, said different filters being adapted to filter out different colours or combinations of colours, characterised in that the contribution to said first optical image obtained utilizing one of said at least two different filters is considerably less than the contribution to said first optical image obtained utilizing the other of said at least two different filters.

2. The method claimed in claim 1, in which each printing plate is a photoconductive surface in a reproduction system using electrostatic images and one on more toners.

3. The method claimed in claim 2, in which the same photoconductive surface is used sequentially to provid the two printing plates.

4. The method claimed in claim 1, in which the two means for recording the first and second optical images are two pieces of photographic film exposed through the said filters to the original, and in which the colouring media are printing inks.

5. The method claimed in Claim 1, in which the filters are chosen from among the colours: blue green and red.

6. The method claimed in claim 1, in which the sheet member is white.

7. The method claimed in claim 1, in which the sheet member is coloured.

8. The method claimed in claim 1, in which the sheet member is yellow.

9. The method claimed in claim 1, in which there are at least two filters interposed between the original and the means for recording the second optical image.

10. The method claimed in claim 4, in which the film constituting the means for recording the first optical image is first exposed to the original with one of said two filters interposed, and then exposed to the original with the other of said two filters interposed.

11. A method according to claim 1, in which said first plate is used for printing red ink, said other of said at least two filters is green and said one thereof is adapted to draw out some of the blue from the original, and wherein said second printing plate is used for printing with blue ink and said filter means used for recording said second optical image consists of a single filter.

12. A method according to claims 5, 6, 7 or 8, wherein said first printing plate is used for printing red ink, said other of said at least two filter is green and said one thereof is adapted to give a blue contribution so that the blue regions of the original would not be obviously red, and wherein said second printing plate is used for printing black ink and said filter means utilized for recording the second optical image is such as to provide the addition of black dots to the "blue" areas.

## Patentansprüche

1. Verfahren zum Aufdrucken einer wirklichkeitsnahen Abbildung eines Originals auf ein Blatt, wobei zwei verschiedene überlagerte Abdrucke mit zwei verschiedenen Farbmedien verwendet werden, wobei das Verfahren die Schritte aufweist; Bereitstellen einer ersten Druckplatte durch Einfügen von Filtereinrichtungen zwischen das Original und einer Einrichtung zum Aufzeichnen einer ersten optischen Abbildung, Bereitstellen einer zweiten Druckplatte durch Einfügen von Filtereinrichtungen zwischen das Original und Einrichtungen zum Aufzeichnen einer zweiten optischen Abbildung und Verwenden der ersten und der zweiten Platte zum Drukken der verschiedenen Abdrucke mit zwei verschiedenen Farbmedien, wobei die erste Druckplatte bereitgestellt wird durch Einfügen von mindestens zwei verschiedenen Filtern zwischen das Original und der genannten Einrichtung zum Aufzeichnen einer ersten optischen Abbildung, die genannten verschiedenen Filter geeignet sind zum Herausfiltern von verschiedenen Farben oder Kombinationen von Farben, dadurch gekennzeichnet, daß der Beitrag zu der ersten optischen Abbildung, der erhalten wird durch Verwendung eines der mindestens zwei verschiedenen Filter wesentlich kleiner ist als der Beitrag zu der ersten optischen Abbildung, der erhalten wird durch verwendung des Anderen der mindestens zwei

EP 0 148 549 B1

verschiedenen Filter.

2. Verfahren nach Anspruch 1, wobei jede Druckplatte eine photoleitende Schicht in einem Reproduktionssystem ist, das elektrostatische Abbildungen und einen oder mehrere Toner verwendet.

3. Verfahren nach Anspruch 2, wobei die gleiche photoleitende Schicht verwendet wird nacheinander zum Bereitstellen der zwei Druckplatten.

4. Verfahren nach Anspruch 1, wobie die zwei Einrichtungen zum Aufzeichnen der ersten und der zweiten optischen Abbildung zwei Stücke eines photographischen Films sind, die durch die Filter mit dem Original belichtet werden und wobei die Farbmedien Druckfarben sind.

5. Verfahren nach Anspruch 1, wobei die Filter gewählt werden aus den folgenden Farben: blau, grün und rot.

6. Verfahren nach Anspruch 1, wobie das Blatt weiß ist.

7. Verfahren nach Anspruch 1, wobei das Blatt farbig ist.

8. Verfahren nach Anspruch 1, wobei das Blatt gelb ist.

9. Verfahren nach Anspruch 1, wobei mindestens zwei Filter zwischen dem Original und der Einrichtung zum Aufzeichnen der zweiten optischen Abbildung eingelegt sind.

10. Verfahren nach Anspruch 4, wobei der Film, der die Einrichtung zum Aufzeichnen der ersten optischen Abbildung bildet, zuerst mit dem Original belichtet wird, wobei das eine der zwei Filter eingelegt ist, und dann mit dem Original belichtet wird, wobei das andere der zwei Filter eingelegt ist.

11. Verfahren nach Anspruch 1, wobei die ersten Platte verwendet wird zum Drucken von rotor Farbe, das andere der mindestens zwei Filter grün ist und das eine Filter geeinet ist zum Herausziehen eines Teils des Blaus aus dem Original, und wobei die zweite Druckplatte verwendet wird zum Drucken mit blauer Farbe und die Filtereinrichtung, die verwendet wird zum Aufzeichnen der zweiten optischen Abbildung, aus einem einzelnen Filter besteht.

12. Verfahren nach Anspruch 5, 6, 7 oder 8, wobei die erste Druckplatte verwendet wird zum Druken roter Farbe, das andere der mindestens zwei Filter grün ist und das eine Filter geeignet ist, einen Blaubeitrag zu liefern, so daß die blauen Bereiche des Originals nicht offensichtlich rot werden und wobei die zweite Druckplatte verwendet wird zum Drucken schwarzer Farbe und die Filtereinrichtung, die verwendet wird zum Aufzeichnen der zweiten optischen Abbildung, so ist, daß schwarze Punkte zu den "blauen" Flächen hinzugefügt werden.

**Revendications**

1. Procéé pour imprimer, sur un élément en forme de feuille, une image réelle d'un original, moyennant l'utilisation de deux impressions différentes superposées avec deux substances colorantes différentes, le procédé incluant les étapes consistant à créer une première plaque d'impression moyennant l'interposition de moyens formant filtres entre l'original et des moyens permettant l'enregistrement d'une première image optique, créer une seconde plaque d'impression moyennant l'interposition de moyens formant filtre entre l'original et des moyens permettant l'enregistrement d'une seconde image optique, et utiliser les première et second plaques pour réaliser les différentes impressions avec deux substances colorantes différentes, la première plaque d'impression étant créée moyennant l'interposition d'au moins deux filtres différents entre l'original et lesdits moyens permettant d'enregistrer une première image optique, et lesdits filtres différents étant adaptés pour éliminer par filtrage différentes couleurs ou combinaisons de couleurs, caractérisé en ce que la contribution à la première image optique, obtenue en utilisant l'un desdits au moins deux filtres différents, est nettement inférieure à la contribution à ladite première image optique, obtenue en utilisant l'autre desdits au moins deux filtres différents.

2. Procédé selon la revendication 1, selon lequel chaque plaque d'impression est une surface photoconductrice dans une système de reproduction utilisant des images électrostatiques et un ou plusieur toners.

3. Procédé selon la revendication 2, selon lequel la même surface photoconductrice est utilisée successivement pour former les deux plaques d'impression.

4. Procédé selon la revendication 1, selon lequel les deux moyens utilisés pour l'enregistrement des première et seconde images optiques sont deux parties d'une pellicule photographique, exposée à l'original moyennant l'interposition desdits filtres, et selon lequel les substances colorantes sont des encres d'impression.

5. Procédé selon la revendication 1, dans lequel les filtres sont choisis parmi les couleurs : bleu, vert et rouge.

6. Procédé selon la revendication 1, selon lequel l'élément en forme de feuille est blanc.

7. Procédé selon la revendication 1, selon lequel l'élément en forme de feuille est coloré.

8. Procédé selon la revendication 1, selon lequel l'élément en forme de feuille est jaune.

9. Procédé selon la revendications 1, selon lequel il existe au moins deux filtres interposés entre l'original et les moyens prévus pour l'enregistrement de la seconde image optique.

10. Procédé selon la revendication 4, selon lequel on expose tout d'abord la pellicule constituant les produits moyens utilisés pour l'enregistrement de la première image optique, à l'original moyennant l'interposition de l'un desdits deux filtres, puis on l'expose à l'original en utilisant l'autre desdits deux filtres interposés.

11. Procédé selon la revendication 1, selon lequel ladite première plaque est utilisée pour réaliser l'impression avec une encre rouge, ledit autre desdits au moins deux filtres est vert et ledit premier filtre est adapté pour extraire une partie du bleu de l'original, et selon lequel ladite seconde plaque d'impression est utilisée pour l'impression réalisée avec l'encre bleue et lesdits moyens formant filtre utilisés pour l'enregistrement de ladite seconde image optique sont constitués par un seul filtre.

12. Procédé selon les revendications 5, 6, 7 ou 8, selon lequel ladite première plaque d'impression est utilisée pour l'impression avec une encre rouge, ledit autre desdits au moins deux filtres est vert et ledit premier filtre est adapté pour apporter une contribution de bleu de manière que les zones bleues de l'original ne soit manifestement pas rouges, et selon lequel ladite seconde plaque d'impression est utilisée pour réaliser l'impression avec une encre noire et lesdits moyens formant filtre utilisés pour l'enregistrements de la second image optique sont tels qu'ils permettent l'addition de points noirs sur les zones ''bleues''.